(19) Europäisches Patentamt
European Patent Office
Office européen des brevets

(11) **EP 2 685 269 A1**

(12) **EUROPEAN PATENT APPLICATION**
published in accordance with Art. 153(4) EPC

(43) Date of publication:
**15.01.2014 Bulletin 2014/03**

(51) Int Cl.:
***G01R 31/36*** (2006.01)

(21) Application number: **11860301.8**

(22) Date of filing: **07.03.2011**

(86) International application number:
**PCT/JP2011/055251**

(87) International publication number:
**WO 2012/120620 (13.09.2012 Gazette 2012/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(71) Applicant: **Hitachi, Ltd.**
**Tokyo 100-8280 (JP)**

(72) Inventors:
• **INOUE, Takeshi**
**Hitachi-shi, Ibaraki 319-1292 (JP)**
• **FUTAMI, Motoo**
**Hitachi-shi, Ibaraki 319-1292 (JP)**
• **KAWAHARA, Youhei**
**Hitachi-shi, Ibaraki 319-1292 (JP)**
• **HONDA, Mitsutoshi**
**Hitachi-shi, Ibaraki 319-1292 (JP)**

(74) Representative: **MERH-IP**
**Matias Erny Reichl Hoffmann**
**Paul-Heyse-Strasse 29**
**80336 München (DE)**

(54) **BATTERY STATE ESTIMATING METHOD AND BATTERY MANAGEMENT SYSTEM**

(57) A battery states estimation method comprises the steps of: measuring an electric current value of a battery B at the electric current value detection section 10 and a terminal voltage value of the battery B at the voltage detection section 12 at a time of charge/discharge of the battery; and calculating at least one of such states of the battery as a state of charge (SOC), a state of health (SOH) and a full charge capacity based on the electric current value and the terminal voltage value as measured, wherein when a change in the measured electric current value per second is at a predetermined value or higher, at least one of the SOC, the SOH and the full charge capacity of the battery is calculated not based on the electric current values and the terminal voltage values measured during a period from an occurrence of the change in the electric current value up to a lapse of a predetermined time, but based on the electric current values and the terminal voltage values measured during a battery charge/discharge period other than the lapsed period.

F I G . 1

EP 2 685 269 A1

**Description**

Technical Field

The present invention relates to a battery states estimation method to detect the states of the battery and a battery control system.

Background Art

Conventionally, such estimation method of the full charge capacity and the SOH (or State of Health) of a battery is known from Patent Document 1 as measuring a voltage of the battery when an electric current does not flow through the battery or the system is in halt; measuring an SOC (or State of Charge) with reference to the map showing the relationship between voltages and SOCs; with the measured SOC and an electric charge (obtained by integrating an electric current in operation) used between one system halt and anther in use, measuring a full charge capacity with the expression 'Electric Charge/ (SOC before the system halt-SOC at the current system halt)' and defining the SOH as the expression '(Full Charge Capacity)/(Initial Full Charge Capacity)'. To note, the system halt is defined therein as one minute or longer after the battery charge/discharge stops.

Citation List

Patent Literature

Patent Document 1: Japanese Unexamined Patent Application Publication  No. Hei6(1994)-242193.

Summary of the Invention

Technical Problem

As with the afore-mentioned conventional method, it is applicable when it is concerned with an automobile and when the system halts frequently occur, but it is hard to apply the same to the system in which the system halt occurs only at the time of maintenance like an electric power system.

Solution to Problem

According to the first aspect of the present invention, the battery states estimation method comprises the steps of: measuring an electric current value and a terminal voltage value of a battery at the time of charge/discharge thereof; and calculating at least one of such states of the battery as an SOC, an SOH and a full charge capacity based on the measured electric current value and terminal voltage value, in which when a change in the measured electric current value per second is at a predetermined value or higher, at least one of the SOC, the SOH and the full charge capacity of the battery is calculated not based on the electric current values and the terminal voltage values measured during the period from the occurrence of the change in the electric current value up to the lapse of a predetermined time, but based on the electric current values and the terminal voltage values measured during a battery charge/discharge period other than the lapsed period.

According to the second aspect of the present invention, the  battery control system comprises: an electric current value detection section to detect an electric current value of the battery; a voltage detection section to detect a terminal voltage value of the battery; an electric current value change detection section to detect a change per second in the electric current value detected at the electric current value detection section that is at a predetermined value or higher; and a battery state calculation section to calculate at least one of such states of the battery as an SOC, an SOH and a full charge capacity not based on the electric current values and the terminal voltage values detected during a period from the detection of the change in the electric current value by the electric current value change detection section up to a lapse of a predetermined time, but based on electric current values and terminal voltage values detected during a battery charge/discharge period other than the lapsed period.

According to the third aspect of the present invention, it is preferred that the smallest polarization time constant among the polarization time constants of the battery or two seconds be adopted for the predetermined time in the battery control system according to the second aspect of the present invention.

According to the fourth aspect of the present invention, it is preferred that an electric current value corresponding to 0.1C by a discharge rate be adopted for the change in the electric current value per second in the battery control system according to any one of the second and third aspects of the present invention.

According to the fifth aspect of the present invention, the battery control system according to any one of the second to fourth aspects of the present invention is provided with a display device to display the battery states calculated at the battery state calculation section.

According to the sixth aspect of the present invention, the battery control system according to any one of the second to fourth aspects of the present invention is provided with an accumulation section in which a predetermined number of the SOCs dated back to retrospectively from the present time among the SOCs calculated at the battery state calculation section are accumulated, in which the full charge capacity is calculated by the battery state calculation section when a difference between a maximum value and a minim value of the SOCs accumulated in the accumulation section is at a predetermined difference in SOC or larger.

According to the seventh aspect of the present invention, in the battery control system according to the sixth aspect of the present invention, the predetermined difference in SOC is defined as 15% in the battery control system according to the sixth aspect of the present invention.

According to the eighth aspect of the present invention, the battery control system according to any one of the sixth and seventh aspects of the present invention is provided with a display device to display the battery states calculated at the battery state calculation section, in which the display device is arranged such that upon an SOC being calculated by the battery state calculation section, it updates the indication of an SOC with the calculated SOC and when the full charge capacity corresponding to the calculated SOC is not calculated, it displays the latest calculated full charge capacity and an SOH of the battery based on the latest full charge capacity.

According to the ninth aspect of the present invention, in the battery control system according to the eighth aspect of the present invention, it is preferred that when the latest calculated full charge capacity and an SOH of the battery based on the latest full charge capacity are displayed, a mode by which the latest full charge capacity and the SOH based on the latest full charge capacity are displayed be different from that by which the full charge capacity corresponding to the calculated SOC is displayed.

According to the tenth aspect of the present invention, in the battery control system according to the second aspect of the present invention, the battery comprises plural battery cells and at least one of an SOC, an SOH and a full charge capacity of the respective battery cells is calculated by the battery states detection section.

According to the eleventh aspect of the present invention, in the battery control system according to the second aspect of the present invention, the battery comprises plural battery blocks each having plural battery cells and at least one of an SOC, an SOH and a full charge capacity of the respective battery blocks is calculated by the battery states detection section.

According to the twelfth aspect of the present invention, in the battery control system according to any one of the tenth and the eleventh aspects of the present invention, the plural battery cells and blocks are connected at least in series and the control system is provided with a synchronization device to synchronize a detection of the respective cells and blocks by the electric current value detection section with a detection of the respective cells and blocks by the voltage detection section such that the detections of an electric current value and a terminal voltage value are synchronously carried out among the plural battery cells and blocks connected in series.

According to the thirteenth aspect of the present invention, the battery control system according to the eleventh aspect of the present invention is provided with a display device to display the battery states calculated at the battery state calculation section and the display device displays the battery states of the respective battery blocks calculated by the battery state calculation section.

Advantageous Effects of Invention

The present invention allows the states of a battery such as the full charge capacity and the SOH thereof to be estimated during the battery charge/discharge with higher precision even when any obvious battery halt might not have happened.

Brief Description of Drawings

Fig. 1 is a functional block diagram showing the arrangement of the battery control system embodied in the present invention.
Fig. 2 is a flow chart explaining the operation steps taken by the battery control system.
Fig. 3 is a view exemplarily showing the relationship between a change in the electric current value and an error in the SOC to be calculated.
Fig. 4 shows one example of a circuit model of the battery.
Fig. 5 is a flow chart showing one example of the detailed operational step at Step S22.

Fig. 6 is a view explaining the operational step for determining an SOC calculation condition.

Fig. 7 shows one example of the open voltage-State of Charge (SOC) map.

Fig. 8 is a graph showing the relationship between the open voltage and the SOC.

Fig. 9 shows a table at the SOC/Electric Charge Accumulation Section 14.

Fig. 10 is a view explaining how to obtain a full charge capacity.

Fig. 11 shows a display example by the display section 19.

Fig. 12 is a view showing the system arrangement when two batteries connected in series are disposed in parallel totaling four batteries in all.

Fig. 13 is a view showing a display example at the display section 913 when the batteries connected in series are disposed in parallel.

Fig. 14 is a block diagram showing the driving system of a rotating electrical machine for vehicles in which the battery control system embodied in the present invention is applied.

Description of Embodiments

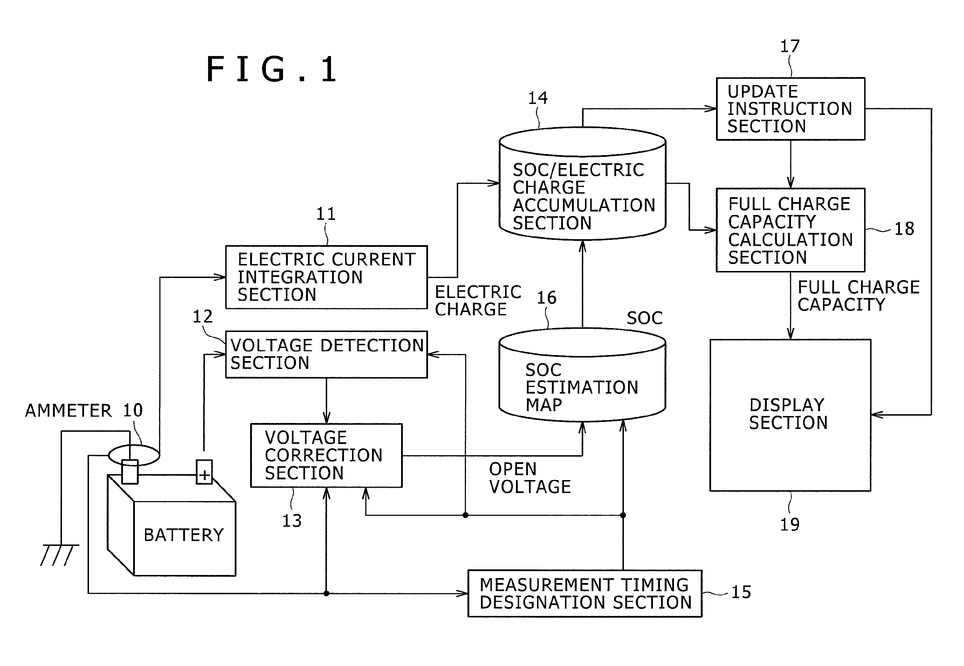

Hereinafter, the preferred mode for carrying out the invention is explained with reference to the accompanying drawings. Figure 1 is a functional bock diagram showing the arrangement of the battery control  system embodied in the present invention. The battery control system according to the present embodiment is applied to the equipment of electric vehicles, an electric power system and so forth, which equipment estimates a full charge capacity of a battery during operation. The battery control system comprises an ammeter 10; an electric current integration section 11; a voltage detection section 12; a voltage correction section 13; an SOC/electric charge accumulation section 14; a measurement timing designation section 15; an SOC estimation map 16; a updating direction section 17; a full charge capacity calculation section 18; and a display section 19.

Among the sections shown in Figure 1, the electric current integration section 11, the voltage correction section 13, the SOC/electric charge accumulation section 14, the measurement timing designation section 15, the SOC estimation map 16, the updating direction section 17 and the full charge capacity calculation section 18 are realized by a software integrated in a controller provided to the equipment system such as a controller in a notebook PC, that in electric vehicles and an electric power system controller, by way of some examples. For instance, in the case of electric vehicles, they are realized by software integrated in the battery controller provided for controlling the battery. Of course, an exclusive controller for the battery control system may well be provided for the execution of the controlling steps.

The software integrated in the controller may well be realized  by any one of the controller of the states detection device (that for measuring a temperature, an electric current and a voltage of the battery) directly connected to the battery, that of a mobile body and that of an electric generator or by various types of controllers in combination. The display section 19 is realized by a separately disposed display device or a display. Hereupon, the display device may well be placed in the vicinity of the battery or placed in a remote location for display in such a manner that information on an SOC and a full charge capacity are transmitted to such remote location through communication lines.

The ammeter 10 measures an electric current charged to/discharged from the battery. The ammeter makes use of a shunt resistor or a Hall effect sensor (refer to Japanese Unexamined Patent Application Publication No. Hei10 (1998)-62453). The voltage detection section 12 as shown in Fig. 1 measures a voltage (an analog value) between the minus pole and the plus pole of a battery B and converts the analog value into a digitalized value so as to send information on the voltage to a voltage correction section 13. The battery B as shown in Fig. 1 includes such rechargeable batteries as a lead storage battery and a lithium ion battery; an electric double-layer capacitor; and a lithium ion capacitor.

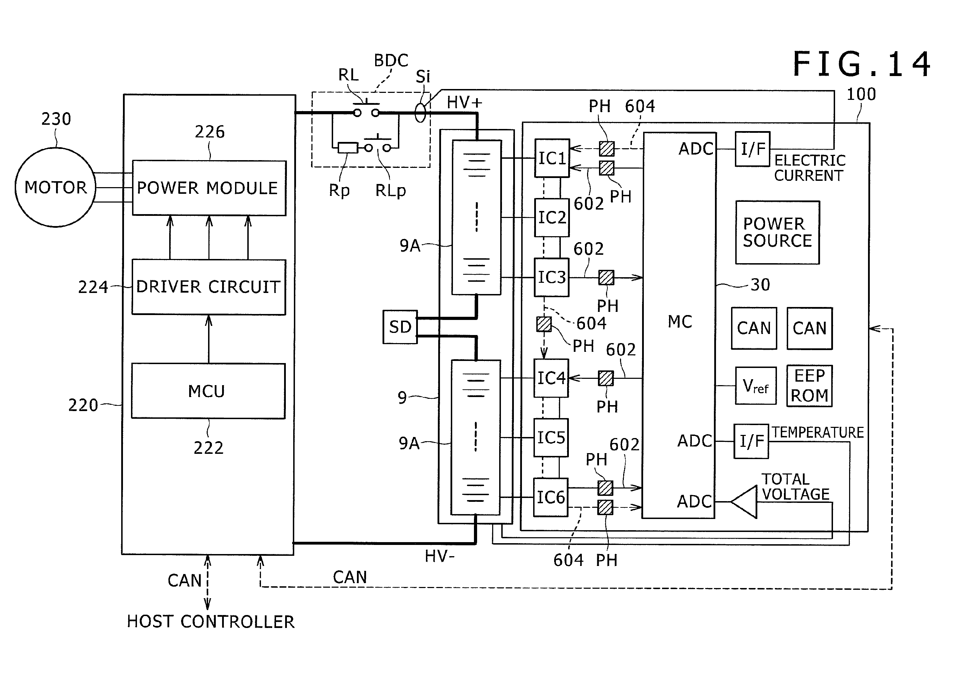

Fig. 14 is a block diagram showing one example of the driving system of a rotating electrical machine for vehicles in which the battery control system according to the present embodiment is applied. The  driving system as shown in Fig. 14 comprises: a battery module 9; a battery monitor device 100 to monitor the battery module 9; an inverter 220 to convert a DC power from the battery module 9 into a three-phase alternating electric power; and a motor for driving a vehicle 230. The battery control system according to the present embodiment is adopted for the battery monitor device 100.

The motor 230 is driven by the three-phase alternating electric power from the inverter 220. The inverter 220 and the battery monitor device 100 are interconnected through a CAN communication, in which the inverter 220 functions as a host controller for the battery monitor device 100. Further, the inverter 220 is operated based on directive information from a farther host controller (not shown in the drawing).

The inverter 220 is provided with a power module 226; an MCU 222; and a driver circuit 224 to drive the power module 226, in which the power module 226 converts a DC power supplied from the battery module 9 into a three-phase alternating electric power to drive the motor 230. To note, the inverter 220 controls the phase of the alternating electric power generated by the power module 226 for the rotor of the motor 230 so as to make the motor 230 actuate as a generator when the vehicle brakes. The three-phase alternating electric power generated by the motor 230 is converted into a DC power by the power module 226 so as to be supplied to the battery module 9. As the result of it, the battery module 9 is charged.

The battery module 9 comprises two battery blocks 9A and 9B connected in series. The respective battery blocks 9A and 9B are provided with 16 battery cells connected in series. The battery blocks 9A and 9B are connected in series through a service disconnect SD for maintenance and inspection in which a switch and a fuse are connected in series. This service disconnect SD opening, the series circuit of the electric circuit is blocked, so that there is no case where an electric current flows even when one circuit connection portion might have been created somewhere between the battery blocks A and B. Such arrangement allows a higher safety to be maintained.

In the strong electric system line HV+ between the battery module 9 and the inverter 220, a battery disconnect unit BDU having a relay RL, a resistor RP and a pre-charge relay RLP is provided. The series circuit of the resistor RP and the pre-charge relay RLP is connected to the relay RL in parallel.

The battery monitor device 100 mainly performs the measurements of a voltage of the respective cells, the total voltage of the cells and the electric current of the respective cells as well as the adjustments of a temperature and a capacity of the respective cells and as such, for which the cell controllers IC1 to IC6 are provided therein. The 16 battery cells provided in the respective battery blocks 9A and 9B are divided into three cells groups, for which respective cells groups one such IC is disposed.

The IC1 to IC6 each communicate with a microcomputer 30 through an insulating device (e.g., photocoupler) PH according to the daisy chain method and comprise a communication system 602 for retrieving a voltage value of the respective cells and transmitting various commands; and a communication system 604 only for transmitting information on an overcharge detection of the respective cells. In an example illustrated in Fig. 14, the communication system 602 is divided into a senior communication path for the IC1 to IC3 of the battery block 9A and a lower communication path for the IC4 to IC6 of the battery block 9B. An electric current sensor Si such as a Hall effect sensor is disposed in the battery disconnect unit BDU, the output of which sensor Si is inputted to the microcomputer 30. Signals on the total voltage and temperature of the battery module 9 are also inputted to the microcomputer 30 and are measured by an AD converter (ADC) of the microcomputer 30. The temperature sensors are provided at plural places in the battery blocks 9A and 9B.

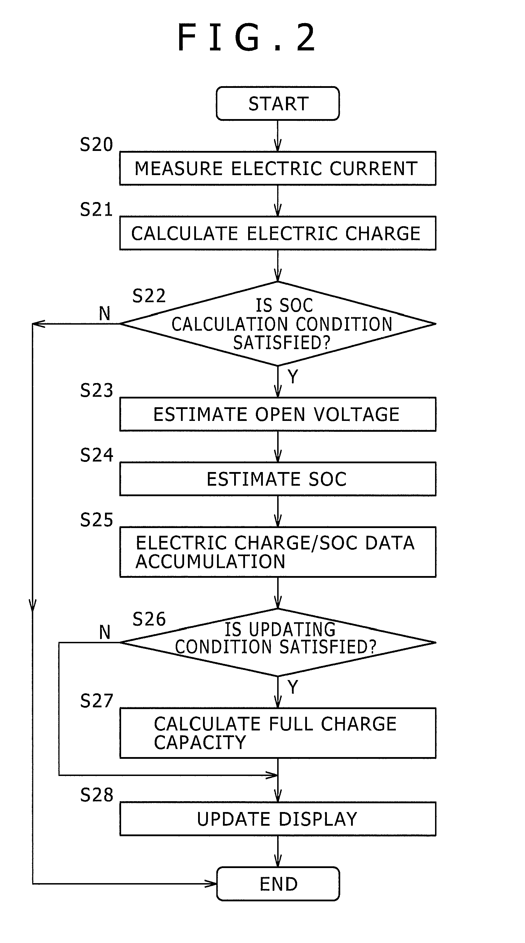

Fig. 2 is a flow chart explaining the operational steps of the battery control system as shown in Fig. 1. The steps as shown in Fig. 2 are executed simultaneously when the apparatus (an electric vehicle, a notebook PC, an electric power system and so forth) in which the battery control system is provided to start operating, which steps are executed regularly and repetitiously every a predetermined time or every time when a predetermined condition holds until the apparatus halts. When the program is executed every a predetermined time, the execution cycle shall be based on a predetermined value (e.g., 100ms).

(Step S20)

At this step, a charge/discharge electric current value of the battery B is measured by the ammeter 10 as shown in Fig. 1.

(Step S21)

At this step, based on the electric current value measured at Step S20, an electric charge (electric current integration) is calculated. Namely, the electric charge (Ah) is calculated with the expression: (Electric Current Value) × (Time), in which the Time signifies the lapse of time from the previous measurement of the electric current to the current measurement thereof and is represented with the afore-mentioned execution cycle. To note, it is provided that the initial value of the electric charge at the time of starting the operation (starting charge/discharge) is defined as 0. This step S21 or the step to calculate the electric charge corresponds to the processing of the electric current integration section 11 as shown in Fig. 1.

(Step S22)

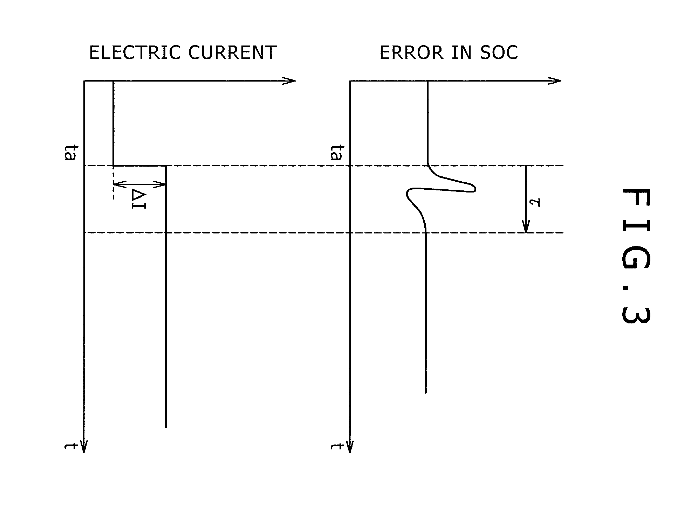

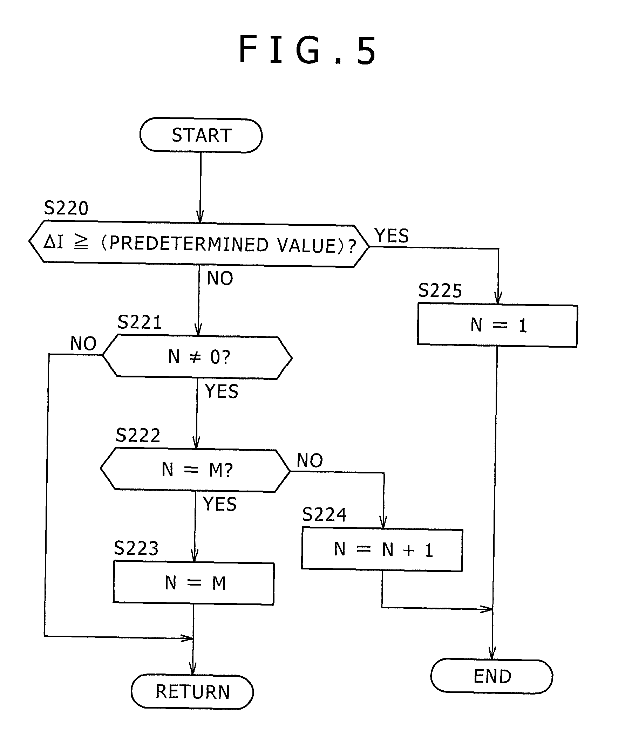

At this step, based on the rate by which the electric current changes, whether or not it matches an SOC calculation condition, namely, whether or not an SOC calculation is performed at the measuring timing at this time (program processing timing as shown in Fig. 2) is determined. Fig. 3 is a view explaining the step of determining whether or not it matches an SOC calculation condition at the step S22 while Fig. 5 is a flow chart showing one example of the detailed processing at the step S22. To note, the processing at the step S22 corresponds to that of a measurement timing designation section 15 as shown in Fig. 1.

In the present embodiment, it is arranged such that based on the electric current and terminal voltage values measured during the operation (during charge/discharge), the battery states (SOC: State of Charge, SOH, Full Charge Capacity) are calculated. During the operation, an electric current value changes according to the state of load (e.g., motor). Then, when the battery states are calculated with an electric current value and a voltage value measured immediately after the electric current value has rapidly changed in use as shown in Fig. 3, an error in the calculation is aggravated.

Fig. 3 is a view exemplarily showing the relationship between a change in the electric current value and an error in the SOC to be calculated, in which it is shown that the electric current value has changed just by $\Delta I$ at the time ta. In this way, when the electric current value has changed, the error in the SOC to be calculated changes to a great extent immediately after the electric current value has changed and subsides after the lapse of some time. Generally speaking, provided that more than two seconds have lapsed after the electric current value has changed, such error subsides to a great extent. In the present embodiment, it is arranged such that the precision with which the battery states (SOC, SOH and Full Charge Capacity) are calculated improves in such a manner that the electric current values and the voltage values measured until a predetermined time has passed after the electric current value has changed are not used for calculating such states. Hereinafter, such predetermined time $\tau$ is referred to as a waiting time $\tau$.

Thus, at the step S22 in Fig. 2 of determining whether or not the rate by which the electric current changes matches an SOC calculation condition, whether or not the change in the electric current value that is at the predetermined value or higher has happened at the processing timing at this time or whether or not the time when the change in the electric current value that is at the predetermined value or higher has happened is during the waiting time is determined. Then, providing that the change in the electric current value that is at the predetermined value or higher has happened or such change has happened during the waiting time, it is determined that it does not meet such calculation condition so that the program as shown in Fig. 2 ends. On the other hand, provided that such change has not happened during the waiting time, the step S22 proceeds to that S23.

Hereupon, the change in the electric current value means such change per one second, in which the definitive value for determining whether or not such change in the electric current value has happened is defined as such change per second being equivalent to the constant factor C (C: discharge ratio) of the initial full charge capacity of the battery B, by way of one example. Generally speaking, it is preferred that such definitive value be set in the order of 0.1C. In the case of a battery whose initial full charge capacity is equal to 5Ah, 0.1C is defined as 0.5A, so that it is determined that such calculation condition is not satisfied when such change by 0.5 A or more per second has happened. The above-mentioned 0.1C is just one example, it may well be 0.3C and so on larger than that. In turn, an optimum value may well be set through the preliminary experiments to be made for a real machine

Further, the waiting time $\tau$ may well be a predetermined value (e.g., the afore-mentioned two seconds) or the shortest time among the polarization time constants of a battery. The longer the waiting time $\tau$ is, the smaller the error in the battery states becomes while it results that the number of measured data to be used for the calculation of the battery states reduces, so that the calculation timing turns out to be hard to gain. Thus, in order to hold the frequency by which the calculation of such states is carried out and the reduction of such error both intact, it is preferred that the waiting time $\tau$ be in the order of seconds in either cases where a certain numerical value is used or where the polarization time constant of a battery is used.

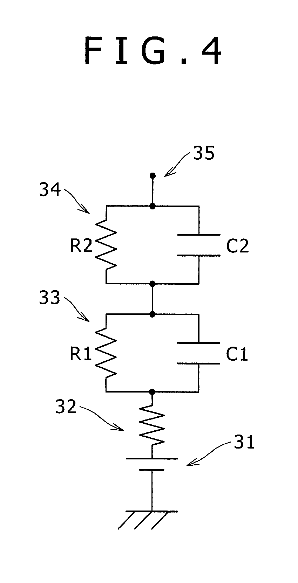

The polarization time constant is explained with reference to Fig. 4, which shows one example of a circuit model of a battery comprising an ideal battery 31 (voltage several hours after the halt of the charge/discharge of a battery); a DC resistor 32; a polarization 1 (33); a polarization 2 (34); and a positive electrode 35. Hereupon, the polarization is expressed as a resistor and a capacitor being connected in parallel. It is provided that the time constant of the polarization 1 is defined as $\tau 1 = C1 \cdot R1$ and that of the polarization 2 is defined as $\tau 2 = C2 \cdot R2$, in which $\tau 1$ is smaller than $\tau 2$. Now, the $\tau 1$ is the time constant of approximately some seconds (depending on a battery, however) and the $\tau 2$ is that ranging from some minutes to some hours. Here, the $\tau 1$ is adopted for the afore-mentioned waiting time $\tau$. To note, the parameters of the respective circuits as shown in Fig. 4 may well be measured with the well-known electrochemical impedance spectroscopy (EIS) (alternating current impedance measurement) in use (refer to 'Principle, Measurement and Analysis: Electrochemical Impedance Spectroscopy' written by Masayuki ITAGAKI and published by Maruzen Company, Limited).

Further, instead of the polarization time constants, the $\tau$ calculated by the following equation (1) may well be adopted for the afore-mentioned waiting time $\tau$. To note, a voltage per SOC1% is to be explained at the step S24 mentioned below. It is provided that an SOC error is a predetermined value (e.g., 5%).

$$\tau = \tau 1 \times \Delta 1 \times R1 / v \quad \dots \quad (1)$$

v = voltage of SOC1%$\times$error in SOC
$\tau 1$: shortest time among polarization time constants
$\Delta I$: difference in electric current values (a value measured at the previous cycle-the current value)
R1: R1 shown in Fig. 4

Then, with reference to Fig. 5, the step of determining whether or not the rate by which the electric current changes matches an SOC calculation condition at S22 is explained in detail. At the step S220, it is determined whether or not the change in the electric current value per second obtained by dividing the difference $\Delta I$ between the electric current value measured by the ammeter 10 at this time and the previously measured value by the execution cycle (or the afore-mentioned 100ms) is at a predetermined value or higher. When it is determined at the step S220 that such change is at a predetermined value or higher, it proceeds to the step S 225, in which the count number N is defined as N=1. The count number N is an index showing the lapse of time after the electric current value has changed by a predetermined value or higher, which lapse of time is expressed as N $\times$ execution cycle (e.g., 100ms). To note, the count number N is stored in the memory of the controller, the value of which number is 0 at the beginning of the operation. When it proceeds from the step S220 to that S 225, on account that such change by a predetermined value or higher has happened, such calculation condition is not satisfied so that the program as shown in Fig. 2 ends.

On the other hand, it being determined at the step S220 that such change is smaller than the predetermined value, it proceeds to the step S221, at which whether or not the count number N is defined as N≠0. At the step S221, it being determined that such number is defined as N≠0, it proceeds to the step S222 while it being determined that the same is defined as N=0, it proceeds to the step S23 as shown in Fig. 2.

At the step S222, it is determined whether or not the count number N satisfies the equation N=M, in which M is an integer satisfying the expression: 'M $\times$ Execution Cycle $\geq \tau >$ (M-1) $\times$ Execution Cycle' and at this step it is determined whether or not the lapse of time has resulted in being more than the waiting time $\tau$. At this step it being determined N≠M or the lapse of time has not reached the waiting time $\tau$, it proceeds to the step S224 so that the count number N is incremented as N=N+1. When the processing at the step S224 ends, the program as shown in Fig. 2 ends.

On the other hand, it being determined N=M at the step S222 or that the lapse of time is the waiting time $\tau$ or longer, it proceeds to the step S223 in which the count number is defined as N=0 and then proceeds to the step S23 as shown in Fig. 2.

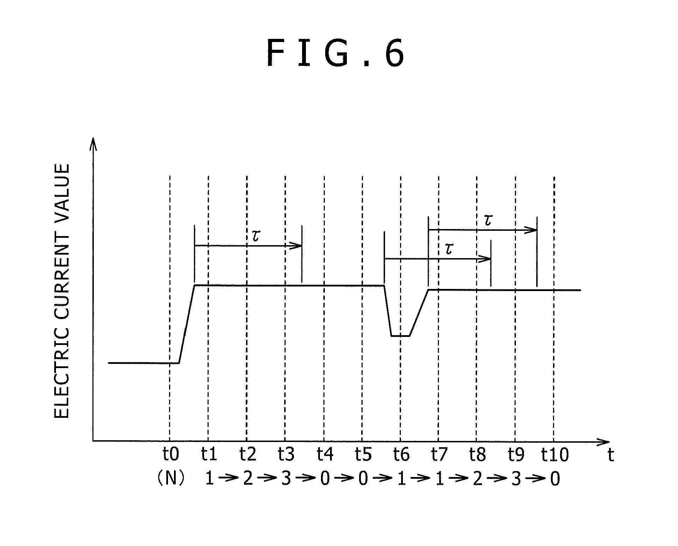

The step of determining whether or not the rate by which the electric current changes matches an SOC calculation condition as mentioned above with reference to Fig. 5 is explained below with reference to Fig. 6 now. Fig. 6 is a view showing the change in the electric current value, in which t0 to t10 indicate the processing timings by which the program as shown in Fig. 2 is executed. The electric current value changes by $\Delta I1$ between the time t0 and that t1 and changes by $\Delta I2$ between the time t5 and that t6 while changing by $\Delta I3$ between the time t6 and that t7. Hereupon, it is assumed that any of the change amounts $\Delta I1$ to $\Delta I3$ is larger than the afore-mentioned predetermined value when each of them is converted into the change in the electric current value per second. Further, M regarding the waiting time $\tau$ is defined as M=3.

At the program processing timing at the time t1, after it is determined YES at the step S220 as shown in Fig. 5 and the count number N is defined as N=1 at the step S225, the program ends without executing the steps (including SOC calculation and so forth) subsequent to the step S23 as shown in Fig. 2. At the step S225, the count number N is defined as N=1, thereby, the calculation of the lapse of time beginning.

At the program processing timing at the subsequent time t2, the electric current value change is zero, so that it is determined NO at the step S220 and it proceeds to the step S221. To note, as the count number N is defined as N=1 in the processing at the previous time t1, it is determined YES at the step S221 and it proceeds to the step S222. At the step S222, after it is determined N≠M(NO) and it is defined as N=1+1=2 at the subsequent step S224, the program ends without executing the steps subsequent to the step S23 as shown in Fig. 2. Also at the program processing cycle at the time t3, as the electric current value change is zero, the steps proceed from S220 via S221 and S222 to S224 likewise and after it is defined as N=2+1=3 at the step S224, the program ends.

At the program processing timing at the time t4 as well, since the electric current change is zero, the steps proceed from S220 via S221 to S222, but on account that it is defined as N=3 (=M), it is determined YES at the step S222. As the result of it, the steps proceed from S222 to S223 in which the count number N is defined as N=0, and then it proceeds to the step S23 as shown in Fig. 2. That is to say, at the time t4, the lapse of time after the electric current value changes by a predetermined value or higher turns out to be equal to or longer than the waiting time $\tau$, so that the battery states such as SOC are calculated based on the electric current value measured at the step S20.

At the program processing timing at the time t5, since the electric current value change is zero as well as the count number is defined as N=0, the steps proceed from S220 via S221 and S222 to S223. Thus, also at this processing timing, the steps subsequent to the step S23 are executed and the battery states such as an SOC are calculated.

At the program processing timing at the subsequent time t6, as the electric current value changes against the electric current value at the time t5 by a predetermined value or higher, it proceeds from the step S220 to that S225, in which the count number N is defined as N=1 and the program ends.

At the program processing timing at the time t7, since the electric current value increases and the electric current value changes by a predetermined value or higher, it is determined YES at the step S220 and the count number N is defined as N=1 again at the step S225. Namely, the time to start measuring the lapse of time is updated to the time t7.

At the program processing timing at the time t8, since the electric current value change is zero, it proceeds from the step S 220 to that S221. On account that the count number N is defined as N=1 at the time t8, the steps proceed from S221 via S222 to S224 at which such number N is defined as N=1+1=2. Then, the program as shown in Fig. 2 ends. The program processing timings at the times t9 and t10 are the same as that of the time t4 as mentioned above. Thus, at the time when the lapse of time after the electric current value change between the time t6 and that t7 results in being equal to or longer than the waiting time τ, the calculation of the battery states such as an SOC is afresh resumed. Taking the steps as shown in Fig. 5 enables the battery states to be calculated after the lapse of a predetermined waiting time when the electric current value changes by a predetermined value or higher, which allows any influence that the electric current value change gives to the calculation of the battery states to be restrained so as to make the precision with which such calculation is carried out improve.

(Explanation of the step S23)

Now, the processing carried out at the step S23 is explained. To note, the same processing corresponds to that of the voltage correction section 13 viewed from the functional block diagram as shown in Fig. 1. At the step S23, electric current and voltage values are measured by the ammeter 10 and the voltage detection section 11 respectively, based on which measured values an open voltage or a terminal voltage of a battery left for several hours in the state of no charge/discharge of the battery is estimated with the following equation (2) in use.

$$\text{Open voltage} = V + I \cdot R - Vf \quad \ldots \quad (2)$$

Where, in the above equation, the definitions of V, I, R and Vf are as follows.

V: Measured Voltage of a Battery
I: Measured Electric Current Value (defined with + in the case of discharge while with - in the case of charge)
R: DC Resistance of a Battery (resistance after the electric current value change and the measurement cycle)
Vf: Polarization Potential of a Battery

Hereupon, V and I of the equation (2) are known because they are measured, but the DC resistance R and the Polarization Potential Vf are unknown, so that they must be estimated. The DC resistance R may well be estimated with the following equation (3) in use or be referred to the values preset in a table whose index includes an SOC (State of Charge) and/or an SOH (State of Health) and a temperature of a battery. When such table is used, a temperature measured by a thermometer provided therewith to measure the temperature of a battery is utilized upon reference being made to such table.

$$R = \Delta V / \Delta I \quad \ldots \quad (3)$$

ΔV = Current Voltage of a Battery-that Measured at one Measurement Cycle before
ΔI = Current Electric Current Value of a Battery-that Measured at one Measurement Cycle before

To note, in the case where the equation (3) is used, it is not always that a value of the resistance is obtained, so that it is required that the electric current value change ΔI be large to some extent (e.g. , such change by 0.1C or larger) . Thus, when a value of the DC resistance R is not always obtained because such change ΔI is small, for countermeasure, the value of such resistance obtained at the time when the previous electric current value change has happened is used. In turn, the method disclosed in Japanese Patent Unexamined Application Publication No. 2000-258513 may well be adopted for the use of such table.
As for the polarization potential Vf, it may well be obtained based on the past voltage and electric current values with the method disclosed in Japanese Patent Unexamined Application No. 2007-171045 in use.

(Explanation of the step S24)

At this step, the State of Charge (SOC) is estimated from an open voltage of a battery. To note, the processing carried out at this step corresponds to that of the SOC estimation map 16 viewed from the functional block diagram as shown in Fig. 1. The State of Charge (SOC) according to the present embodiment is defined by the following equation (4), but for the actual estimation method, a preliminarily prepared SOC-Open voltage Map is used.

$$SOC = 100 \times Current\ Charge\ Amount\ [Ah]/Initial\ Full\ Charge$$

$$Capacity[Ah] \ldots (4)$$

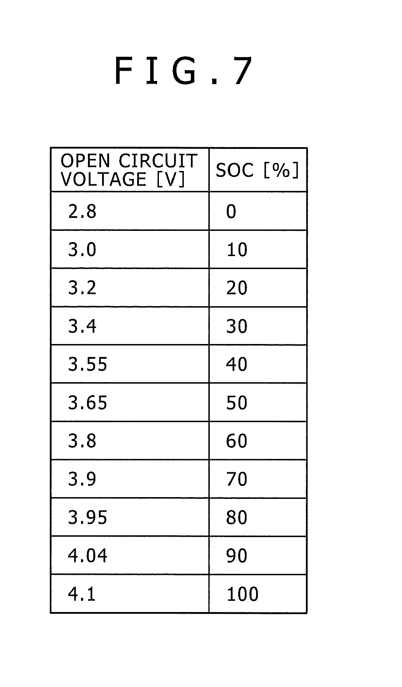

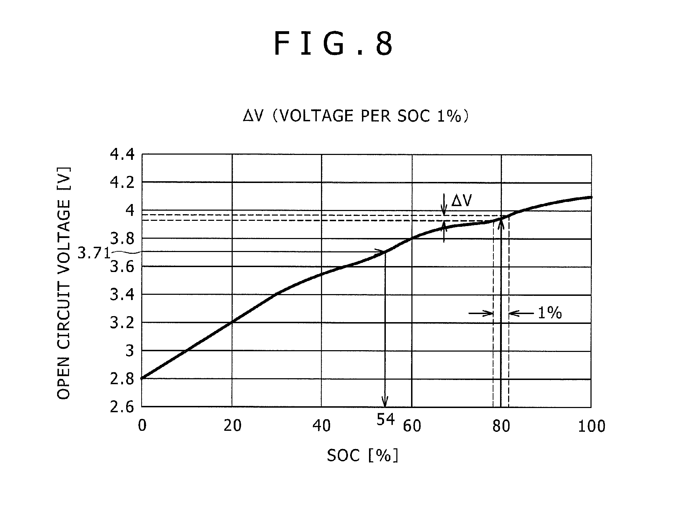

Fig. 7 shows one example of such SOC-Open voltage Map, which Map shows the case when the relationship between the open voltage and the SOC of a battery does not change according to the temperature of a battery and comprises the group of data that subdivides 0% to 100% of SOC into 10%. The Map as shown in Fig. 7 is represented with a graph as shown in Fig. 8.

By way of one example, how to obtain SOC with such Map in use is explained where the open voltage estimated at the step S23 is 3.71V. According to the graph showing the relationship between Open voltage and SOC as shown in Fig. 8, the SOC corresponding to the open voltage: 3. 71V is defined as SOC=54%. However, when such SOC is actually estimated based on the Map as shown in Fig. 7, it is estimated according to the following method as explained below.

In the first place, data nearest to 3.71V is searched from the group of open voltage data shown in the left column of Fig. 7. Herein, it corresponds to 3.8V in the seventh step thereof. Then, 3.71V is smaller in value than 3.8V, so that data at the sixth step that is a voltage data by one rank below 3.8V is selected. The SOC may well be obtained through the linear interpolation between those two points (data), in which case the SOC corresponding to 3.65V is 50% while that corresponding to 3.8V is 60%, so that the actual SOC is estimated as 54[%] based on the calculation: 50 + (60-50) × (3.71-3.65). To note, herein, the linear interpolation is adopted for such estimation, but data estimation through the well-known spline interpolation with four points (data) including further data on 3.55V and 3.9V in use may well be adopted. The method disclosed in 'Spline Function and its Application (New Applied Mathematics in Series: Series No. 20)' written by Fuj iichi YOSHIMOTO and published in January 1979 by Kyoiku-Shuppan Co., Ltd. is adopted for such spline interpolation, by way of one example.

Hereupon, how to obtain a voltage per SOC1% as referred in the afore-mentioned equation (1) is explained. Fig. 8 shows the characteristics of the ideal battery 31. Now, such SOC1% at SOC80% ranges from 79.5% to 80.5%. Then, the difference between an open voltage at 80.5% and that at 79.5% results in being ΔV. This difference ΔV in open voltages is defined as a voltage per SOC1%. Herein, an example at SOC80% is illustrated, but the same calculation is adopted for the other SOC values (e.g., SOC40%).

(Explanation of the step S25)

At this step, data pair (electric charge and SOC) accumulated in the SOC/electric charge accumulation section 14 are added. To note, the processing carried out at this step corresponds to that of the SOC/electric charge accumulation section 14 viewed from the functional block diagram as shown in Fig. 1. As for how to add such data pair, recordation may well be carried out each time when such pair are acquired, but it may well be carried out when the previously recorded SOC has changed by 1% or larger without such recordation being carried out each time when they are acquired.

When a great amount of data cannot be accumulated due to the memory capacity or when an error deterioration is prevented by deleting the olden data, the data accumulated in the SOC/electric charge accumulation section 14 may well be deleted where appropriate. In this case, the data to be deleted is such data as having been accumulated therein for a certain period, by way of one example. How to decide such certain period T depends on an error in electric charge resulting from an error in the ammeter.

More concretely speaking, an error in the ammeter 10 is divided into an offset error and a white noise, the values of which are defined as Io [A] and Iw [A] respectively (those values shall be referred to the catalogue of the ammeter or are to be actually measured beforehand). Then, providing that an error in the predefined full charge capacity is defined as Qe[Ah], T[h] satisfying the following equation (5) is referred to as the afore-mentioned certain period T. The error Qe is defined as Qmaxxs with an error rate ε of the full charge capacity Qmax in use. The value of such error rate ε may well be 5% by way of one example. What is indicated with ΔT in the equation is a current integration time width [h].

$$Io \times T + Iw \times \sqrt{T} \times \Delta T = Qe \ldots (5)$$

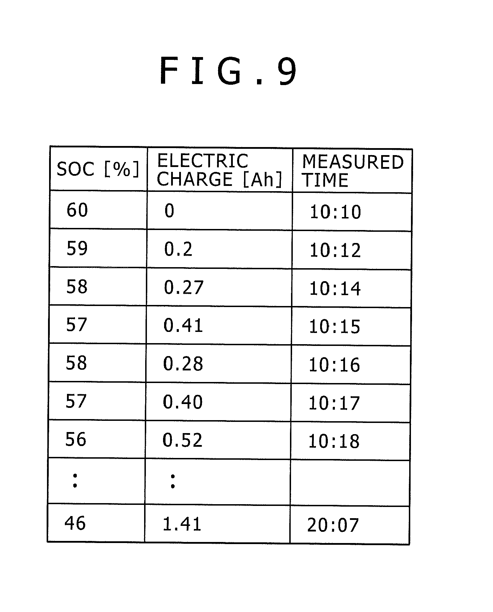

Fig. 9 is a view showing a table at the SOC/electric charge accumulation section 14, with reference to which view one example of the processing carried out at the SOC/electric charge accumulation section 14 is explained. The data pair comprising an SOC and an electric charge is stored therein along with its measurement time. The electric charge is an integrated value from the initial value, the unit thereof being Ah and the case where the same is discharged being rendered positive. According to the example as shown in Fig. 9, the data of the measurement time at 10:10 corresponds to the initial value, in which the initial value of an SOC is 60% while that of an electric charge is 0%. Then, when the SOC has changed by 1% from the previous SOC, it is arranged such that the SOC and electric charge at that time are stored.

Since the SOC reduces by 1% from the second to fourth steps of the table, the data pairs obtained at the time of discharge are shown. As the case where the electric charge is discharged is rendered positive, the same increases. On the other hand, the SOC increases from the fourth to fifth steps while the electric charge decreases. Namely, it indicates that charging is carried out between the fourth and fifth steps. The data pair at the lowest step indicates the latest data, in which it is shown the SOC is 46% while the electric charge is 1.41 Ah.

The example as shown in Fig. 9 illustrates the case where the relationship between the SOC and the open voltage does not change according to a temperature. However, for a battery in which such relationship changes according to a temperature, such tables as shown in Fig. 9 are prepared for each temperature and they are selected according to a value pointed by a thermometer separately mounted on the battery. The data at the respective measurement times are made use of upon deleting the olden data so as to prevent an error deterioration or deleting the data so as to prevent the memory from being overflowed as commented above.

(Explanation of the step S 26)

At this step, whether or not the full charge capacity is updated is determined. When the updating conditions are satisfied, it proceeds to the step S 27 whereas in the negative, it proceeds to the step S28. To note, the processing carried out at this step corresponds to that of the updating direction section 17 viewed from the functional block diagram as shown in Fig. 1.

As for the updating conditions of the step S26, among the group of the data stored in the table as shown in Fig. 9, difference between the minimum and maximum values of the SOC is picked up and the full charge capacity is updated when such difference is at a predetermined value or higher. Further, even though the same might have been updated once, it is supposed that the same is updated as well after the subsequent data is added thereto when such conditions are satisfied. For such predetermined value, such fixed values as 20% or 15% are adoptable, by way of some examples.

(Explanation of the step S27)

At this step, based on the pair data of the SOC and the electric charge, the full charge capacity of a battery is estimated. To note, the processing carried out at this step corresponds to that of the full charge capacity calculation section 18 viewed from the functional block diagram as shown in Fig. 1. For the estimation of the full charge capacity, the right and left sides relationship of the following equation (6) is used, in which an SOC is defined as x while an electric charge is defined as y and an inclination of the straight line showing the relationship between x and y is obtained as a full charge capacity. Further, it is supposed that the target data pairs are the whole data accumulated in the SOC/electric charge accumulation section 14.

$$\text{Electric Charge} = \text{Full Charge Capacity} \times \text{SOC} + \text{Constant} \ldots (6)$$

The least squares method is adopted in practice for obtaining a full charge capacity, by way of one example. Specifically, the method disclosed in the following non-patent literature: 'Elementary Course of Statistics' compiled by Statistics Class at Faculty of Liberal Arts of University of Tokyo and published by University of Tokyo Press on September 25, 2001, Issue No.20 may well be applied. Hereupon, the reason such inclination is used is because it can cope well with a bias error deviation accompanied with the SOC estimation, which is due to the fact that for instance, when the deviation in the SOC estimation occurs, it does not affect such inclination even though the linear least-square fitting might move up and down on the coordinate.

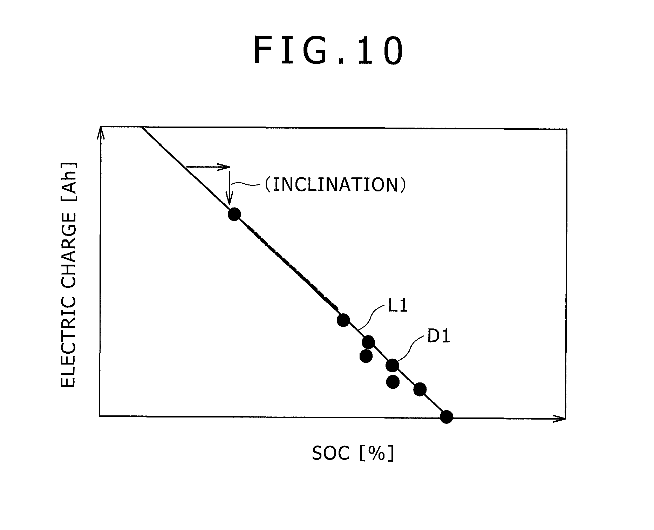

How to obtain a full charge capacity is explained with reference to Fig. 10. Fig. 10 shows a coordinate in the vertical axis of which an electric charge [Ah] is scaled while in the transverse axis of which an SOC [%] is scaled and in which the data as shown in Fig. 9 are plotted. The data at the fifth step of Fig. 9 corresponds to the point D1 as shown in Fig. 10 and L1 is the linear least-square fitting obtained from the group of data as plotted thereon. The inclination of such fitting L1 indicates a full charge capacity. According to the example as shown in Fig. 10, it is defined as the inclination being equal to 0.1Ah/SOC% so that a full charge capacity is calculated as 10Ah that is 100 times as large as 0.1Ah. Further, an SOH (State of Health) is calculated as the percentage ratio of [Full Charge Capacity] / [Full Charge Capacity of a new Battery].

(Explanation of the step S28)

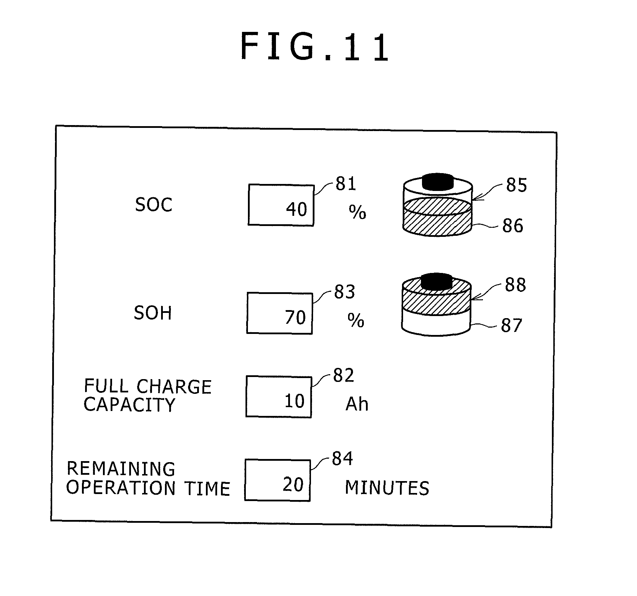

At this step, the processing of renewing the display at the display section 19 is carried out. Fig. 11 shows a display example on the screen of the display section 19. According to the example as shown in Fig. 11, it is arranged such that an SOC, an SOH and the remaining operating time are displayed thereon. In Fig. 11, the reference numerals 81, 82, 83 and 84 indicates an SOC, a full charge capacity, an SOH and the remaining operating time respectively.

As with the SOC, it is arranged such that it is displayed not only with the numerical value by percentage, but also with the bar illustration 86 visually easy to see in addition to the battery illustration 85. Thus, the largeness of such bar 86 indicates what can be left in the battery. As for the SOH, it is also arranged such that it is displayed not only with the numerical value by percentage, but also with the bar illustration 87 in addition to the battery illustration 88.

The screen display by this display section 19 is updated each time when the calculation of the SOC is carried out, but when it proceeds from the step S22 to that S28, as a full charge capacity is not calculated, the values of the SOH and full charge capacity at the processing timing at this time are rendered indefinite. In this case, their last values of the battery previously operated may well be displayed with their display color changed. Alternatively, instead of changing their display color, those values may well be blinked on the screen. Such display color permits a user to recognize that the values of the SOH and full charge capacity are not the latest ones.

The value of the SOC may well be such that a value obtained by adding the result of '100$\times$ (Current Electric Charge-an Electric Charge Accumulated in the SOC/Electric Charge Accumulation Section based on its Latest Data) / (Full Charge Capacity)' to the latest value of the SOC measured at the SOC Estimation Map 16 as shown in Fig. 1. The remaining operating time may well be calculated by the following equation (7) . The average electric current may well be an average value of the values measured during the latest 30 minutes (which may well be on the latest one hour instead).

$$\text{The Remaining Operating Time = (Current SOC–Lowest SOC)} \times \text{Full}$$

$$\text{Charge Capacity/Average Current} \times 100 \ \dots \ (7)$$

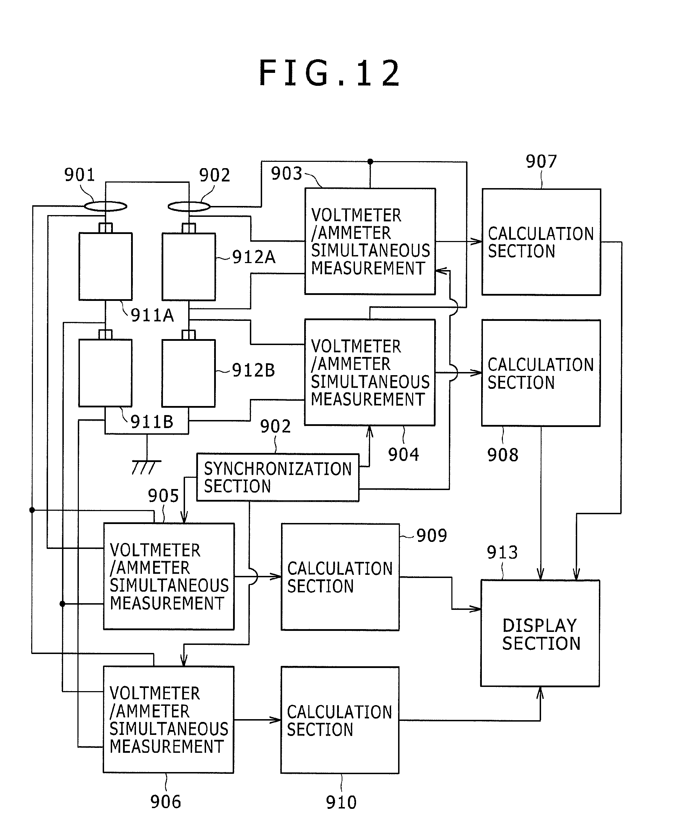

According to the afore-mentioned embodiment, it is exemplified with just one battery. However, the same arrangement as commented in the above embodiment can be also applied to the case where plural batteries connected in series are disposed in parallel. Hereafter, such case is described with reference to an example illustrated in Fig. 12.

Fig. 12 shows an example in which two batteries connected in series are disposed in parallel totaling four batteries in all. Namely, the batteries 911A and 911B connected in series and those 912A and 912B connected in series are disposed in parallel. At the respective points where those batteries are connected in series, the respective ammeters 901 and 902 are disposed. The measurement sections 903, 904, 905 and 906 corresponding to the respective batteries 911A, 911B, 912A and 912B are disposed, and these sections cyclically and simultaneously measure an electric current and a voltage of the corresponding batteries.

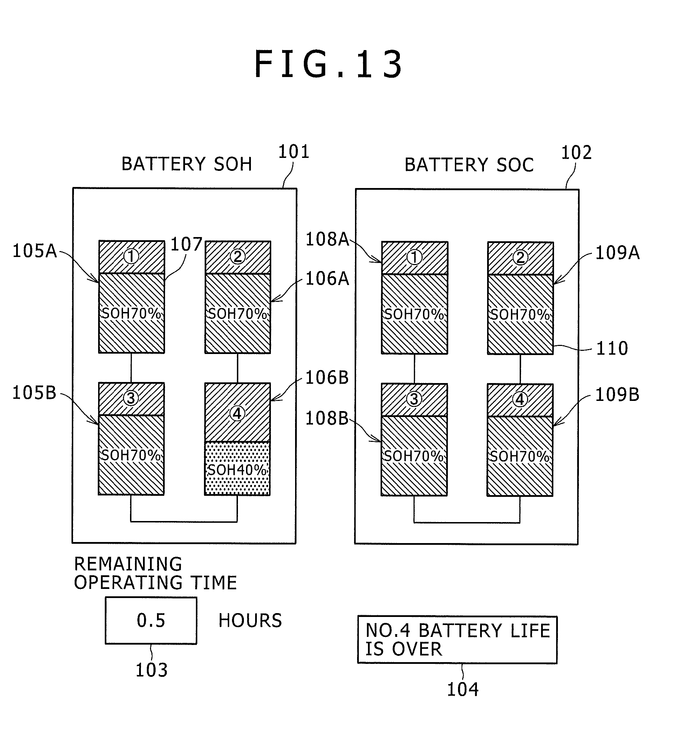

Between the measurement sections 903 and 904 that are disposed at the batteries 912A and 912B connected in series, the measurement of an AD (Analog to Digital) circuit of the current sensor and the voltage sensor respectively synchronously starts. Likewise, between the measurement sections 905 and 906 that are disposed at the batteries 911A and 911B connected in series, the measurement of an AD (Analog to Digital) circuit of the current sensor and the voltage sensor respectively synchronously starts. Thus, a synchronizing signal is inputted from the synchronization section 920 into the respective measurement sections 903, 904, 905 and 906. Further, the calculation sections 907 to 910 are disposed for the respective measurement sections 903 to 906 to make the former carry out the afore-mentioned processing as shown in Fig. 2. The display section 913 makes such display as shown in Fig. 13 based on the calculation results of those calculation sections 907 to 910.

Then, how to calculate the remaining operating time over the group of batteries as a whole is explained. The full charge capacity and the SOC of the respective batteries 911A, 911B, 912A and 912B are calculated at the corresponding calculation sections 907 to 910 as shown in Fig. 12. The capacity and the remaining operating time of the whole batteries are calculated based on the following equations (8) and (9). It is provided that the average electric current is an average value of the values measured during the latest 30 minutes (which may well be on the latest one hour instead), by way of one example.

$$\text{The Capacity [Ah]} = \{\text{Full Charge Capacity of Battery 911A} \times \text{SOC of Battery 911A}$$

$$+ \text{ Full Charge Capacity of Battery 911B} \times \text{SOC of Battery 911B}$$

$$+ \text{ Full Charge Capacity of Battery 912A} \times \text{SOC of Battery 912A}$$

$$+ \text{ Full Charge Capacity of Battery 912B} \times \text{SOC of Battery 912B}\} \ / \ 100 \ ...$$

(8)

$$\text{The Remaining Operating Time} = \text{The Capacity/Average Current} \ ...$$

(9)

Fig. 13 is a view showing a display example. The display section 913 comprises: an SOH display screen 101 to display an SOH of the respective batteries in bundle; an SOC display screen 102 to display an SOC of the respective batteries in bundle; a remaining operating time display screen to display the remaining operating time over the group of batteries as a whole; and a display screen 104 to display which battery deteriorates.

The SOH display section 101 displays an SOH (State of Health: expressed herein with a percentage ratio of [Full Charge Capacity] / [Full Charge Capacity of a new Battery]) of the respective batteries 911A , 911B, 912A and 912B whose respective pair in series is disposed in parallel. In Fig. 13, the corresponding SOH display of the battery 911A as shown in Fig. 12 is the display 105A, which is shown with the bar illustration 107 in addition to the numerical indication 'SOH70%'. The corresponding SOH displays of the batteries 911B, 912A and 912B are the displays 105B, 106A and 106B.

The SOC display screen 102 is arranged in the same way as the SOH display screen 101, in which the corresponding SOC displays of the batteries 911A, 911B, 912A and 912B are the displays 108A, 108B, 109A and 109B, those displays being shown with the bar illustration 110 in addition to the numerical indication 'SOC70%'.

The display screen 104 to display which battery deteriorates displays the No. of the battery, the value of which SOH is at a predetermined threshold or lower. This threshold may well be fixed as 50%, by way of one example. Further, when there might be a battery whose full charge capacity is not definite, an SOH value of the corresponding battery on the SOH display screen 101 as shown in Fig. 13 is displayed in grey with such value measured at the previous operation in use while a value on the remaining operating time display screen is 103 calculated with the full charge capacity at the previous operation provisionally used and is displayed in grey. Those values displayed in grey are displayed in black once they are rendered definite.

As described above, according to the present embodiment, the battery states estimation method comprises the steps of: measuring an electric current value and a terminal voltage value of a battery at the time of charge/discharge thereof; and calculating at least one of such states of the battery as an SOC, an SOH and a full charge capacity based on the measured electric current value and terminal voltage value, the method being characterized in that when a change in the measured electric current value per second is at a predetermined value or higher, at least one of the SOC, the SOH and the full charge capacity of the battery is calculated not based on the electric current values and the terminal voltage values measured during the period from the occurrence of the change in the electric current value up to the lapse of a predetermined time, but based on the electric current values and the terminal voltage values measured during a battery charge/discharge period other than the lapsed period.

In this way, calculating the afore-mentioned battery states with the electric current value and terminal voltage detected during the battery charge/discharge in use allows the battery states to be estimated even when there has been no obvious case where the battery comes to a halt in the fields of the electric power system and electric vehicles.

Further, an electric current value and a terminal voltage value immediately after the electric current has changed by a predetermined value or higher result in being transitional ones, so that calculating the battery states with such transitional values in use results in inviting unreliable values large in error, but in the present embodiment, when the electric current change per second is at a predetermined value or higher upon such values being measured during the battery charge/discharge, it is arranged such that such values as being detected during the transitional period from the occurrence of such change up to the lapse of a predetermined time are not used, so that the battery states can be calculated with far higher precision. To note, also at the time when the electric current begins flowing at the operation start, the same step as being taken when the electric current has changed by a predetermined value or higher may well be taken.

The battery control system according to the present embodiment comprises : an ammeter 10 to detect an electric current value of a battery B; a voltage detection section 12 to detect a terminal voltage value of the battery B; a measurement timing designation section 15 to detect change per second by a predetermined value or higher in the electric current value detected at the ammeter 10; and a battery state calculation section (e.g., a full charge capacity calculation section 18 to  calculate a fill charge capacity) to calculate at least one of such states of the battery as an SOC, an SOH and a full charge capacity not based on electric current values and terminal voltage values detected during the period from the time when such change is detected by the measurement timing designation section 15 up to the lapse of a predetermined time, but based on such values as detected during the battery charge/discharge period other than the lapsed period.

Further, when plural batteries are provided as shown in Fig. 12, the measurement sections 903, 904, 905 and 906 are provided for the corresponding batteries 911A, 911B, 912A and 912B, which sections synchronously and cyclically measure an electric current value and a voltage of the corresponding batteries. Then, the states of the respective batteries in plurality may well be calculated. As the result of it, such states for each battery can be calculated with higher precision.

Moreover, providing the display sections 19 and 913 that are display devices to display the battery states calculated at the battery state calculation section facilitates a user to recognize such states. Upon a full charge capacity being displayed, when such capacity corresponding to an SOC is not calculated, a full charge capacity calculated at the latest and an SOH of the battery based on such, latest capacity are displayed. This permits a full charge capacity and an SOH along with an SOC to be constantly displayed, so that a user can be aware of the summary of the battery states even when a full charge  capacity might not be calculated.

Further, when a full charge capacity calculated at the latest and an SOH of the battery based on such latest capacity are displayed, differentiating the mode by which such latest capacity and the corresponding SOH are displayed from that by which a full charge capacity corresponding to the calculated SOC is displayed facilitates a user to be aware that the values of a full charge capacity and an SOH are not current, but the latest ones.

Furthermore, displaying the states of the respective batteries provided in plurality facilitates a user to be aware of which battery deteriorates, which allows such maintenance as exchanging the same to be appropriately carried out in a timely manner.

In the above embodiment, a battery B represents a control unit, in which the respective battery cells included in the battery module 9 as shown in Fig. 14 may well be a battery B or the respective cell groups may well be a battery B or the battery blocks 9A and 9B respectively may well be a battery B. It is of course that the battery module 9 may well be a battery B. According to the example as shown in Fig. 14, the whole battery cells are connected in series, but they may well be connected in series as well as in parallel. Further, when the display as illustrated in Fig. 13 is performed, the respective battery cells included in the battery module 9 may well be displayed, but realistically speaking, it is preferred that an average value of  each unit for battery cells exchange or the respective battery blocks 9A and 9B as shown in Fig. 14, for instance, be displayed.

Along with various embodiments and their modified examples, the present invention is described above, but such embodiments may well be used alone or in combination. This leads to giving the advantageous effect of each embodiment alone or synergistic effects in combination. It shall be appreciated that the present invention is not limited to the above-mentioned embodiments in any manner as far as the characteristics features of the invention are not ruined and that other embodiments available within the technical concepts of the invention are encompassed in the technical scope thereof.

## Claims

1. battery states estimation method comprising the steps of: measuring an electric current value and a terminal voltage value of a battery at a time of charge/discharge of the battery; and calculating at least one of such states of the battery as an SOC, an SOH and a full charge capacity based on the electric current value and the terminal voltage value as measured,
   wherein when a change in the measured electric current value per second is at a predetermined value or higher, at least one of the SOC, the SOH and the full charge capacity of the battery is calculated not based on the electric current values and the terminal voltage values measured during a period from an occurrence of the change in the electric current value up to a lapse of a predetermined time, but based on the electric current values and the terminal voltage values measured during a battery charge/discharge period other than the lapsed period.

2. A battery control system comprising:

   an electric current value detection section to detect an electric current value of a battery;
   a voltage detection section to detect a terminal voltage value of the battery;
   an electric current value change detection section to detect a change per second in the electric current value detected at the electric current value detection section that is at a predetermined value or higher; and
   a battery state calculation section to calculate at least one of such states of the battery as an SOC, an SOH and a full charge capacity not based on the electric current values and terminal voltage values detected during a period from a detection of the change in the electric current value by the electric current value change detection section up to a lapse of a predetermined time, but based on the electric current values and the terminal voltage values detected during a battery charge/discharge period other than the lapsed period.

3. The battery control system according to claim 2 wherein one of the smallest polarization time constant among polarization time constants of the battery and two seconds is adopted for the predetermined time.

4. The battery control system according to claim 2 or 3 wherein an electric current value corresponding to 0.1C by a discharge rate is adopted for the change in the electric current value per second.

5. The battery control system according to any one of claims 2 to 4 provided with a display device to display the battery states calculated at the battery state calculation section.

6. The battery control system according to any one of claims 2 to 4, including an accumulation section in which a predetermined number of the SOCs dated back to retrospectively from a present time among the SOCs calculated at the battery state calculation section are accumulated,
   wherein the full charge capacity is calculated by the battery state calculation section when a difference between a maximum value and a minimum value of the SOCs accumulated in the accumulation section is at a predetermined difference in SOC or larger.

7. The battery control system according to claim 6, wherein the predetermined difference in SOC is defined as 15%.

8. The battery control system according to claim 6 or 7, including:

   a display device to display the battery states calculated at the battery state calculation section, wherein
   upon an SOC being calculated by the battery state calculation section, the display device updates an SOC indication with the calculated SOC, and
   when the full charge capacity corresponding to the calculated SOC is not calculated, the display device displays a latest calculated full charge capacity and an SOH of the battery based on the latest full charge capacity.

9. The battery control system according to claim 8, wherein when the latest calculated full charge capacity and an SOH of the battery based on the latest full charge capacity are displayed, a mode by which the latest full charge capacity and the SOH based on the latest full charge capacity are displayed differs from that by which the full charge capacity corresponding to the calculated SOC is displayed.

10. The battery control system according to claim 2, wherein
    the battery includes a plurality of battery cells, and
    at least one of an SOC, an SOH and a full charge capacity of the respective battery cells is calculated by the battery states detection section.

11. The battery control system according to claim 2, wherein
    the battery comprises plural battery blocks each having a plurality of battery cells, and
    at least one of an SOC, an SOH and a full charge capacity of the respective battery blocks is calculated by the battery states detection section.

12. The battery control system according to claim 10 or 11, wherein
    the plurality of battery cells and blocks are connected at least in series, and
    the control system includes a synchronization device to synchronize a detection of the respective cells and blocks by the electric current value detection section with a detection of the respective cells and blocks by the voltage detection section such that the detections of the electric current value and the terminal voltage value are synchronously carried out among the plurality of battery cells and blocks connected in series.

**13.** The battery control system according to claim 11, including:

a display device to display the battery states calculated at the battery state calculation section,
wherein the display device displays the battery states of the respective battery blocks calculated by the battery
state calculation section.

# FIG.1

# F I G . 2

```
          ┌──────────┐
          │  START   │
          └────┬─────┘
               │
S20  ┌─────────▼──────────────────┐
     │  MEASURE ELECTRIC CURRENT  │
     └─────────┬──────────────────┘
               │
S21  ┌─────────▼──────────────────┐
     │  CALCULATE ELECTRIC CHARGE │
     └─────────┬──────────────────┘
               │
         S22   ◇ IS SOC
      N ◇ CALCULATION CONDITION ◇
        ◇      SATISFIED?      ◇
               │ Y
S23  ┌─────────▼──────────────────┐
     │   ESTIMATE OPEN VOLTAGE    │
     └─────────┬──────────────────┘
               │
S24  ┌─────────▼──────────────────┐
     │       ESTIMATE SOC         │
     └─────────┬──────────────────┘
               │
S25  ┌─────────▼──────────────────┐
     │  ELECTRIC CHARGE/SOC DATA  │
     │       ACCUMULATION         │
     └─────────┬──────────────────┘
               │
         S26   ◇ IS UPDATING
      N ◇ CONDITION SATISFIED? ◇
               │ Y
S27  ┌─────────▼──────────────────┐
     │   CALCULATE FULL CHARGE    │
     │        CAPACITY            │
     └─────────┬──────────────────┘
               │
S28  ┌─────────▼──────────────────┐
     │      UPDATE DISPLAY        │
     └─────────┬──────────────────┘
               │
          ┌────▼─────┐
          │   END    │
          └──────────┘
```

# FIG.3

# F I G . 4

# F I G . 5

START

S220

$\Delta I \geqq$ (PREDETERMINED VALUE)? — YES

NO

S221

NO — N ≠ 0?

YES

S222

N = M? — NO

YES

S223

N = M

S225

N = 1

S224

N = N + 1

RETURN

END

# F I G . 6

# F I G . 7

| OPEN CIRCUIT VOLTAGE [V] | SOC [%] |
|---|---|
| 2.8 | 0 |
| 3.0 | 10 |
| 3.2 | 20 |
| 3.4 | 30 |
| 3.55 | 40 |
| 3.65 | 50 |
| 3.8 | 60 |
| 3.9 | 70 |
| 3.95 | 80 |
| 4.04 | 90 |
| 4.1 | 100 |

# FIG.8

ΔV (VOLTAGE PER SOC 1%)

# F I G . 9

| SOC [%] | ELECTRIC CHARGE [Ah] | MEASURED TIME |
|---|---|---|
| 60 | 0 | 10:10 |
| 59 | 0.2 | 10:12 |
| 58 | 0.27 | 10:14 |
| 57 | 0.41 | 10:15 |
| 58 | 0.28 | 10:16 |
| 57 | 0.40 | 10:17 |
| 56 | 0.52 | 10:18 |
| ⋮ | ⋮ | |
| 46 | 1.41 | 20:07 |

# FIG.10

# FIG.11

SOC  [ 40 ]  81  %  85 86

SOH  [ 70 ]  83  %  88 87

FULL CHARGE CAPACITY  [ 10 ]  82  Ah

REMAINING OPERATION TIME  [ 20 ]  84  MINUTES

# FIG.12

# FIG.13

BATTERY SOH    101          BATTERY SOC    102

105A     107     108A           109A

①      ②       106A

SOH70%    SOH70%       SOH70%    SOH70%

110

106B

105B      ③      ④     108B     ③      ④    109B

SOH70%    SOH40%      SOH70%    SOH70%

REMAINING
OPERATING TIME

| 0.5 | HOURS |

103

| NO.4 BATTERY LIFE IS OVER |

104

FIG.14

EP 2 685 269 A1

<table>
<tr><td colspan="2" align="center">**INTERNATIONAL SEARCH REPORT**</td><td>International application No.<br>PCT/JP2011/055251</td></tr>
</table>

**A. CLASSIFICATION OF SUBJECT MATTER**
*G01R31/36*(2006.01)i

According to International Patent Classification (IPC) or to both national classification and IPC

**B. FIELDS SEARCHED**

Minimum documentation searched (classification system followed by classification symbols)
G01R31/36

Documentation searched other than minimum documentation to the extent that such documents are included in the fields searched
Jitsuyo Shinan Koho        1922-1996    Jitsuyo Shinan Toroku Koho    1996-2011
Kokai Jitsuyo Shinan Koho    1971-2011   Toroku Jitsuyo Shinan Koho    1994-2011

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2002-189066 A (Hitachi, Ltd.),<br>05 July 2002 (05.07.2002),<br>paragraphs [0006] to [0011]<br>(Family: none) | 1-13 |
| Y | JP 2006-340560 A (Fujitsu Ten Ltd.),<br>14 December 2006 (14.12.2006),<br>paragraphs [0082] to [0088]<br>(Family: none) | 1-13 |
| Y | JP 6-242193 A (Toyota Motor Corp.),<br>02 September 1994 (02.09.1994),<br>paragraph [0024]<br>& US 5539318 A | 5,8,9,13 |

☒ Further documents are listed in the continuation of Box C.    ☐ See patent family annex.

| | |
|---|---|
| *    Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search<br>    25 May, 2011 (25.05.11) | Date of mailing of the international search report<br>    07 June, 2011 (07.06.11) |
|---|---|
| Name and mailing address of the ISA/<br>    Japanese Patent Office | Authorized officer |
| Facsimile No. | Telephone No. |

Form PCT/ISA/210 (second sheet) (July 2009)

| | INTERNATIONAL SEARCH REPORT | International application No.<br>PCT/JP2011/055251 |
|---|---|---|

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2006-292492 A  (Nissan Motor Co., Ltd.),<br>26 October 2006 (26.10.2006),<br>paragraphs [0048] to [0049]<br>(Family: none) | 6-9 |
| Y | JP 2009-168720 A  (Honda Motor Co., Ltd.),<br>30 July 2009 (30.07.2009),<br>paragraphs [0027] to [0053]<br>(Family: none) | 10-13 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI61994242193 B
- JP HEI10199862453 B
- JP 2000258513 A
- JP 2007171045 A

**Non-patent literature cited in the description**

- Elementary Course of Statistics. Statistics Class at Faculty of Liberal Arts of University of Tokyo. University of Tokyo Press, 25 September 2001